# EUROPEAN PATENT SPECIFICATION

(11) **EP 3 457 829 B1**
(45) Date of publication and mention of the grant of the patent: **19.01.2022**
(21) Application number: 16905273.5
(22) Date of filing: 14.10.2016
(51) Int. Cl.: H05K 7/20

(54) **COOLING SYSTEM OF WORKING MEDIUM CONTACT TYPE FOR HEAT DISSIPATION OF COMPUTER AND DATA CENTRE**
KÜHLSYSTEM VOM ARBEITSMEDIUMKONTAKTTYP ZUR WÄRMEABLEITUNG EINES COMPUTERS UND DATENCENTERS
SYSTÈME DE REFROIDISSEMENT DU TYPE À CONTACT DE MILIEU DE TRAVAIL POUR LA DISSIPATION DE CHALEUR D'UN CENTRE DE CALCUL ET DE DONNÉES

(30) Priority: 16.06.2016 CN 201610445639; 16.06.2016 CN 201620608893 U
(43) Date of publication of application: 20.03.2019
(73) Proprietor: Guangdong Hi-1 New Materials Technology Research Institute Co., Ltd., Guangzhou, Guangdong 510635 (CN)
(72) Inventor: WANG, Wei, Guangzhou Guangdong 510635 (CN)
(74) Representative: Meyer, Thorsten
(86) International application number: PCT/CN2016/102109
(87) International publication number: WO 2017/215161

(56) References cited:
- WO-A1-97/43887
- CN-A- 1 225 232
- CN-A- 101 534 627
- CN-A- 101 534 627
- CN-A- 104 302 158
- CN-A- 105 658 037
- CN-A- 105 658 037
- CN-U- 203 279 429
- US-A- 4 407 136
- US-A1- 2008 066 889
- US-A1- 2012 243 169
- US-B2- 8 724 322

## Description

### FIELD OF THE INVENTION

The present invention relates to Computer And Data Center cooling field, in particular to a working substance contacted cooling system for computer and data center.

### BACKGROUND OF THE INVENTION

With the rapid development of communication technology and electronics industry, high-density server deployment becomes an inevitable trend in the development of data centers, and efficient computers for various applications are also emerging. Smaller, more integrated and more high power density are developed in core compute components such as server components, processors, memory, etc. While the components possess high power performance, the heat dissipation problem is more obvious than before. If the heat dissipation problem cannot be effectively solved, it will inevitably limit the development depth of the high-performance data center. In the current technical field, the traditional air conditioning refrigeration mode is still applied in the data center. The air conditioning system is running all year round to provide an ambient temperature suitable for the normal operation of the data center; the air conditioning refrigeration COP has its limit value, and as the thermal load of the data center increases, the power consumption relative to the air conditioning system is large, and there also exits noise pollution.

US2008/066889A1 discloses a heat exchanging fluid return manifold for a liquid cooling system, wherein the liquid cooling system cools a plurality of electronic components connected in parallel. A pump delivers a cooling fluid from a reservoir to a supply manifold wherein it splits into distinct branch lines. Preferably, the branch lines feed coolant to individual spray modules. The resulting liquid and vapor mixture exits the spray modules via return branches. Each individual return branch feeds into a return manifold, wherein the manifold is sized sufficiently for the separation of liquid and vapor under the influences of gravity.

CN101534627A discloses an integral spray cooling system, wherein a working substance supplied from a reservoir is cooled by means of a cooler, pumped to a spray device by means of a pump, and atomized into droplets by means of the spray device, then the atomized droplets are sprayed onto electronic components to remove the heat, and after that the working substance flows through holes of the plate and back into the reservoir.

CN105658037A discloses an integrated liquid-cooling heat dissipation case.

US2012243169A1 discloses a targeted liquid cooling for a system.

WO9743887A1 discloses a heat spreader system and a method for cooling heat generating components.

Moreover, in the data center of a high-density server, due to the excessive heat generated by a single cabinet or a small scale of several cabinets and the unreasonable airflow, it may lead to high local heat phenomena that cannot be solved by the air conditioning system. In the single computer cooling technology, in addition to the traditional forced air cooling technology, the mature application of heat pipe technology can help solve the heating problem of high power core computer components, but there still exits technical blind spots, and technical adaptability, structural life and other issues are still to be further verified.

### BRIEF SUMMARY OF THE INVENTION

The object of the present invention is to provide a working substance contacted cooling system for computer and data center, so that the problem in the prior art that high local heat phenomena that cannot be solved by the air conditioning system caused by the excessive heat generated by a single cabinet or a small scale of several cabinets and the unreasonable airflow leads to overhigh junction temperature of the electronic device, thus worsening the performance or causing failure of the device.

The solving solution for the above problem according to the present invention as defined by independent claim 1 is as below:
a working substance contacted cooling system for computer and data center comprises:
a server cabinet;
a liquid working substance box arranged at a bottom of the server cabinet;
a liquid working substance cooling device configured to cool the heat-conducting liquid working substance with good insulation in the liquid working substance box;
a main conduit dispenser vertically arranged, which is in communication with the liquid working substance box through a main conduit; and
a liquid working substance pump arranged in or outside the liquid working substance box and the liquid working substance pump is in communication with the main conduit dispenser,
the system further comprises: a plurality of partition plates with holes or grooves, which are parallelly and horizontally arranged at different heights and on which server components are mounted; a plurality of liquid working substance spraying pipes, a plurality of spray orifices being uniformly arranged on each said liquid working substance spraying pipe, each said liquid working substance spraying pipe being horizontally arranged above the server components at the different heights respectively and being in communication with the main conduit dispenser; spraying directions of the spray orifices being corresponding to positions of the server components; a top of the liquid working substance box is opened to allow heat-conducting liquid working substance with good insulation from the liquid working substance box sprayed on the server components to fall back into the liquid working substance box and the working substance contacted cooling system is configured that no phase change occurs in the process of heat transferring when the heat-conducting liquid working substance with good insulation directly contacts the server components that need heat dissipation.

The liquid working substance spraying pipes are horizontally arranged above the server components for each layer and the spraying liquid fully covers the server components, and the server components are cooled by spraying operation of the system, so as to improve the cooling efficiency.

Preferably, the spray orifices are connected with spraying nozzles; liquid sprayed by the spraying nozzles fully covers the server components

The invention has the beneficial effects that the low-temperature, insulated and heat-conducting liquid working substance in the liquid working substance box is directly sprayed onto the server components through the spray orifices, and the sprayed fog liquid heat-conducting working substance directly contacts with the surface of the components, absorbs the heat generated by the components, and then falls back into the liquid working substance box. In this cycle, the liquid working substance ceaselessly transfers heat of the electronic device, and the cooling liquid working substance directly contacts the server components that need heat dissipation and no phase change occurs in the process of heat transferring, and there isn't any intermediate medium and heat transfer conversion. Significant advantages are listed in the following:
1. The sprayed liquid working substance forms an atomizing liquid film on the surface of heat generating device, and heat conduction of the liquid film has excellent heat transferring characteristics such as small flow, large temperature difference, high heat transfer coefficient and high heat flux density.
2. The Tilt spraying component for spraying liquid working substance has the advantages of simple structure, low power consumption, mature manufacturing technology and high reliability.
3. The liquid working substance can directly contact the surface of the single heat generating device, and improve the heat conduction efficiency by reducing the contact thermal resistance and reducing the indirect heat transfer structure. At the same time, the simpler the heat transferring process and structure, the higher the reliability and controllability.
4. Under the same ambient temperature, the temperature difference of direct contact cooling is controllable. Compared with the non-direct contact heat transfer method, the temperature of the heating surface of the device can be lowered and the junction temperature can be lowered, which helps to improve the working life and reliability of the server components.
5. Through adopting spraying for heat dissipation, the effective contact area (heat exchange area) between the liquid working substance and the heating surface will increase, so that the theoretical heat transfer efficiency will increase (the heat exchange amount is proportional to the area), and the effective utilization ratio of the liquid working substance is higher.
6. The heat transfer performance of liquid working fluid is generally better than the forced air convection, and compared with the traditional forced convection air cooling system that requires fresh air unit and some complicated structural design, the liquid cooling technology according to the present invention needs more simple design, and the spraying structure for direct contact is more simple, saving costs and extending device working life.
7. The working substance in the liquid working substance box is cooled continuously, so as to ensure an effective temperature difference for heat exchange (usually 5 to 10°C) between the liquid working substance and the server components for effective cooling.

Based on the above technical solutions, the present invention can be improved as follows:
The present invention provides a working substance contacted cooling system for computer and data center as described above, and further, a side wall of lower part of the server cabinet extends to form a side wall of the liquid working substance box, so that the side wall of the liquid working substance box and the side wall of the lower part of the server cabinet are formed in one piece; or, the liquid working substance box comprises a first liquid working substance box and a second liquid working substance box, a top of the first liquid working substance box is opened, a side wall of lower part of the server cabinet extends to form a side wall of the first liquid working substance box and the side wall of the first liquid working substance box and the side wall of the lower part of the server cabinet are formed in one piece, and the second liquid working substance box arranged outside the server cabinet is in communication with the first liquid working substance box.

The beneficial effects of the above further limitation are as follows: In the open cycle, non-phase-change liquid working substance is sprayed on the heating surface, the heat exchange area of the liquid working substance and the heating surface will increase, so that the theoretical heat transfer efficiency will be improved, the effective utilization ratio of the liquid working substance is higher, and the cooling efficiency is improved.

The present invention provides a working substance contacted cooling system for computer and data center as described above, and further, the system further comprises a filter installed at a front end of a liquid inlet of the liquid working substance pump.

The beneficial effects of the above further limitation are as follows: The filter is arranged at the front end of the liquid working fluid substance pump, and is used for filtering the liquid working substance for heat transferring in repeated circulation to ensure purity of the liquid working substance, thereby preventing damage to the pump body and clogging of the nozzle caused by impurities, and during the spraying process, there is no phase change occurring in the liquid working substance, so the system recycling does not require the working substance recovery equipment, and only the general filter is used to filter the impurities generated by the working substance in the open cycle, and the system adaptability and reliability are higher.

The present invention provides a working substance contacted cooling system for computer and data center as described above, and further, the liquid working substance cooling device comprises a water chiller; the water chiller comprising a refrigerant compressor, a refrigerant conveying tube, a refrigerant returning tube and an evaporator; an outlet of the refrigerant compressor being in communication with one end of the evaporator through the refrigerant conveying tube, and an inlet of the refrigerant compressor being in communication with the other end of the evaporator through the refrigerant returning tube; the evaporator being arranged in the liquid working substance box.

The present invention provides a working substance contacted cooling system for computer and data center as described above, and further, the liquid working substance cooling device is a radiating fin installed outside the liquid working substance box.

The present invention provides a working substance contacted cooling system for computer and data center as described above, and further, the liquid working substance cooling device comprises a first heat exchange section outside the liquid working substance box and a second heat exchange section in the liquid working substance box; a refrigerant outlet of the first heat exchange section being in communication with a refrigerant inlet of the second heat exchange section, and a refrigerant outlet of the second heat exchange section being in communication with a refrigerant inlet of the first heat exchange section.

The present invention provides a working substance contacted cooling system for computer and data center as described above, and further, the system further comprises a blower used to cool the radiating fin or the first heat exchange section.

The present invention provides a working substance contacted cooling system for computer and data center as described above, and further, the liquid working substance is selected from the group consisting of natural mineral oil, silicone oil, vegetable oil, transformer oil, heat transfer oil and mixtures thereof.

The beneficial effects of the above further limitation are as follows: The above liquid working substance should be heat conducting liquid working substance with good insulation, to ensure the insulating performance of the working substance and avoid contact with the server components and then conducting electricity, resulting in electronic devices damage and system scrapping. The liquid working substance generally has a high thermal conductivity, and can directly contact with the heat-generating electronic devices in the spraying way, thereby realizing efficient heat dissipation of server.

The server components of the present invention comprise a processor, a hard disk, a memory, a system bus, etc. The heat generated by the server components is mainly derived from CPU, GPU, memory and other components. By adopting the cooling medium, which is insulated liquid working substance for heat conducting, as non-polar material, to spray directly on the server components, the electronic, electrical equipment and circuit will not be affected and the hardware will not be damaged.

### BRIEF DESCRIPTION OF THE DRAWINGS

Fig. 1 is a main view of a working substance contacted cooling system for computer and data center according to an embodiment not falling within the scope of the claims;
Fig. 2 is a schematic diagram of a working substance contacted cooling system for computer and data center according to the first embodiment of the present invention;
Fig. 3 is a schematic diagram of a working substance contacted cooling system for computer and data center according to the second embodiment of the present invention;
Fig. 4 is a schematic diagram of a working substance contacted cooling system for computer and data center according to the third embodiment of the present invention;
Fig. 5 is a schematic diagram of a working substance contacted cooling system for computer and data center according to the fourth embodiment of the present invention;

### List of reference numerals::

- 1.: liquid working substance box
- 101.: insulated liquid working substance
- 2.: partition plates
- 3.: server components
- 4.: main conduit dispenser
- 5.: main conduit
- 6.: liquid working substance spraying pipes
- 7.: spraying nozzles
- 8.: liquid working substance pump
- 9.: filter
- 10.: refrigerant compressor
- 11.: refrigerant conveying tube
- 12.: refrigerant returning tube
- 13.: evaporator
- 14.: radiating fin
- 15.: blower
- 16.: the first heat exchange section
- 17.: the second heat exchange section
- 18.: water chiller
- 601: spray orifice

### DETAILED DESCRIPTION OF ILLUSTRATED EMBODIMENTS

The principles and features of the present invention will be described in the following with reference to the drawings. The embodiments to be described are intended to be illustrative only and not to limit the scope of the present invention.

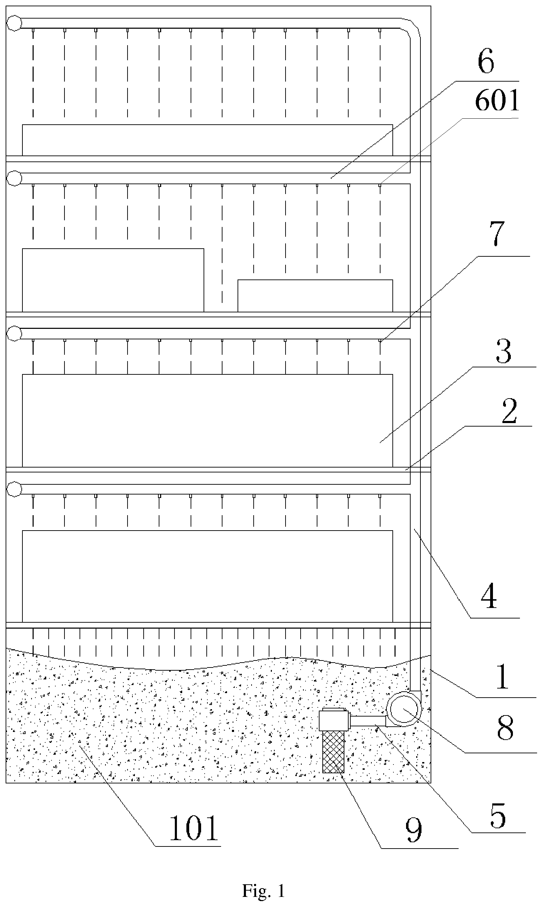

With reference to Figures 1-5, a working substance contacted cooling system for computer and data center comprises a server cabinet 301; a liquid working substance box 1, the liquid working substance box 1 arranged at a bottom of the server cabinet 301; a plurality of parallelly and horizontally arranged partition plates 2 with holes or grooves, on which server components 3 are mounted; a main conduit dispenser 4 vertically arranged, which is in communication with the liquid working substance box 1 through a main conduit 5; a plurality of liquid working substance spraying pipes 6, a plurality of spray orifices 601 being uniformly arranged on each said liquid working substance spraying pipe, each said liquid working substance spraying pipe being horizontally arranged above the server components 3 for each layer and being in communication with the main conduit dispenser 4. That is, the liquid working spray pipes 6 are arranged in parallel above the server components 3 for each layer and the spraying liquid fully covers the server components 3. Spraying directions of the spray orifices 601 are corresponding to positions of the server components 2; liquid working substance sprayed on the server components 3 flows back into the liquid working substance box 1. Specifically, the spray orifices 601 are connected with spraying nozzles 7, which are directly facing the server components 3 and the liquid can be sprayed onto the server components 3 more accurately.

In the embodiment of the present invention, one end of the main conduit dispenser 4 is connected with the liquid working substance pump 8, and N (N ≥ 1) three-way joints are arranged at different heights, on which liquid working substance spraying pipes 6 for the same heights are mounted . Each said liquid working substance spraying pipe is provided with a plurality of spraying nozzles 7; each said spraying nozzle sprays towards the components that need heat dissipation. The spraying nozzles should be made of materials with good insulation and engineering strength; According to one embodiment of the present invention, the low-temperature, insulated and heat-conducting liquid working substance in the liquid working substance box 1 is directly sprayed onto the server components 3 through the spray orifices 601, and the sprayed fog liquid heat-conducting working substance directly contacts with the surface of the components, absorbs the heat generated by the components, and then falls back into the liquid working substance box 1. In this cycle, the liquid working substance ceaselessly transfers heat of the electronic device, and the cooling liquid working substance directly contacts the server component that need heat dissipation and no phase change exists in the process of heat transferring, as well as any intermediate medium and heat transfer conversion. The spraying structure can be simpler, thus saving cost, extending device working life and improving the cooling effect.

According to a working substance contacted cooling system for computer and data center in one embodiment of the present invention, a top of the liquid working substance box 1 is opened , a side wall of lower part of the server cabinet 301 extends to form a side wall of the liquid working substance box 1, so that the side wall of the liquid working substance box 1 and the side wall of the lower part of the server cabinet 301 are formed in one piece; or, the liquid working substance box 1 comprises a first liquid working substance box and a second liquid working substance box, a top of the first liquid working substance box is opened, a side wall of lower part of the server cabinet 301 extends to form a side wall of the first liquid that the side wall of the lower part of the server cabinet 301 are formed in one piece, and the second liquid working substance box arranged outside the server cabinet 301 is in communication with the first liquid working substance box 1. According to the above structure, a liquid working substance box 1 can be formed by directly taking advantage of the original space of the server cabinet 301, and the liquid sprayed on the server components 3 from a plurality of liquid working substance spraying pipes 6 directly flows back into the liquid working substance box 1 formed by the lower part of the cabinet. The system framework is simple, and the heat exchange area of the liquid working substance and the heating surface will increase, so that the theoretical heat transfer efficiency will be improved, the effective utilization ratio of the liquid working substance is higher, and the cooling efficiency is improved.

In the above embodiments, specifically, the main conduit dispenser 4 is vertically arranged, a plurality of liquid working substance spraying pipes 6 are uniformly arranged on the main conduit dispenser 4, one end of each liquid working substance spraying pipe is communicated with the main conduit dispenser 4, the other end of each liquid working substance spraying pipe is blocked.

In an embodiment of the present invention, the system further comprises a liquid working substance pump 8, the liquid working substance pump 8 is arranged in the liquid working substance box 1 and communicated with the main conduit dispenser 4; specifically, the system further comprises a filter 9, which is installed at a front end of a liquid inlet of the liquid working substance pump 8. By arranging the liquid working substance pump 8 and the filter 9, it will ensure circulation performance and purity of the liquid working substance, thus preventing damage to the pump body and clogging of the nozzle caused by impurities. The system adaptability and reliability are higher.

In the above embodiments, a plurality of liquid working substance spraying pipes 6 may also be vertically arranged on three sides of the server components 3. The liquid can be sprayed towards three sides of the server components3 to improve the cooling efficiency.

In embodiments of the present invention, specifically, the system comprises a liquid working substance cooling device, which is used to cool liquid working substance in the liquid working substance box 1. The working substance in the liquid working substance box 1 is cooled continuously, so as to ensure an effective temperature difference for heat exchange (usually 5 to 10°C) between the liquid working substance and the server components3 for effective cooling.

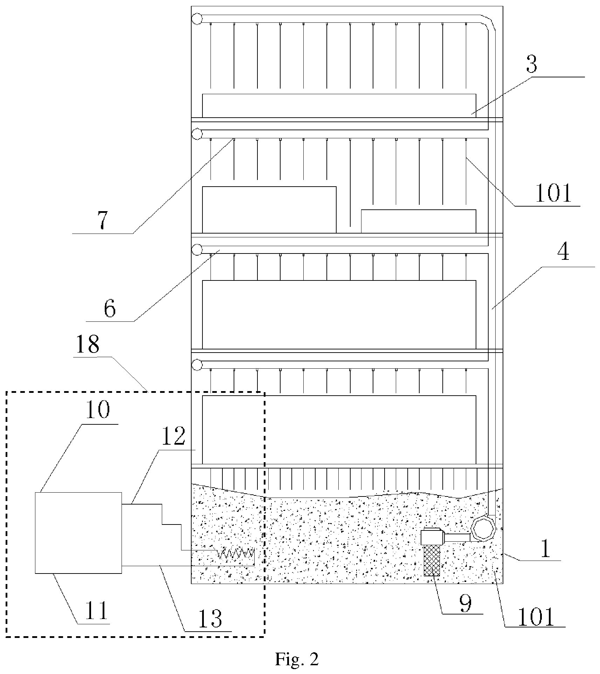

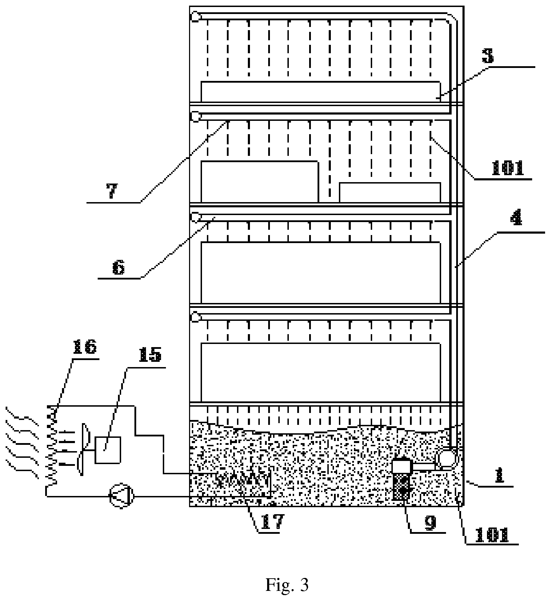

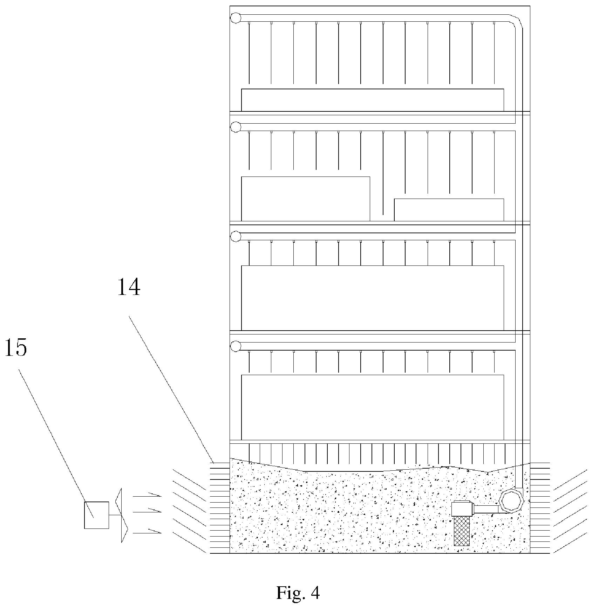

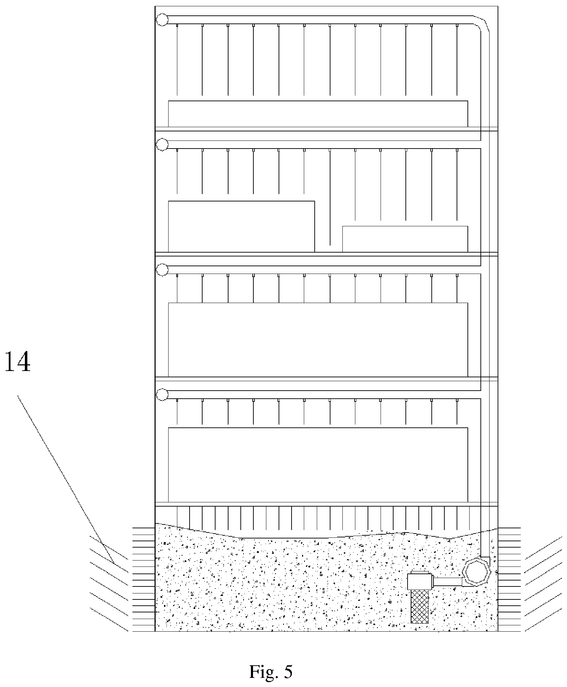

The above liquid working fluid cooling device can be realized in the following manners: Firstly, with reference to Figure 2, the liquid working substance cooling device comprises a water chiller 18; the water chiller 18 comprises a refrigerant compressor 10, a refrigerant conveying tube 11, a refrigerant returning tube 12 and an evaporator 13; an outlet of the refrigerant compressor 10 is in communication with one end of the evaporator 13 through the refrigerant conveying tube 11, and an inlet of the refrigerant compressor 10 is in communication with other end of the evaporator 13 through the refrigerant returning tube 12; the evaporator 13 is arranged in the liquid working substance box 1. Secondly, with reference to Figure 5, the liquid working substance cooling device is a radiating fin 14 installed outside the liquid working substance box 1. Thirdly, with reference to the Fig. 4, with reference to Figure 4, a blower 15 is disposed outside a radiating fin 14 outside the liquid working substance box 1 taken as the liquid working substance cooling device; the blower is used to cool down the radiating fin 14. Fourthly, the liquid working substance cooling device comprises a first heat exchange section 16 arranged outside the liquid working substance box 1 and a second heat exchange section 17 arranged in the liquid working substance box 1; a refrigerant outlet of the first heat exchange section 16 is in communication with a refrigerant inlet of the second heat exchange section 17 through a tube, and a refrigerant outlet of the second heat exchange section 17 is in communication with a refrigerant inlet of the first heat exchange section 16 through a tube, a refrigerant of the circulation loop of the first heat exchange section and the second heat exchange section may be water or air. Fifthly, with reference to Figure 3, the liquid working substance cooling device comprises a first heat exchange section 16 arranged outside the liquid working substance box 1 and a second heat exchange section 17 arranged in the liquid working substance box 1; a refrigerant outlet of the first heat exchange section 16 is in communication with a refrigerant inlet of the second heat exchange section 17 through a tube, and a refrigerant outlet of the second heat exchange section 17 is in communication with a refrigerant inlet of the first heat exchange section 16 through a tube, a refrigerant of the circulation loop of the first heat exchange section and the second heat exchange section may be water or air; a blower 15 is disposed outside the first heat exchange section 16 for cooling down the first heat exchange section 16.

In one preferred embodiment of the present invention, the insulated liquid working substance 2 is selected from the group consisting of natural mineral oil, silicone oil, vegetable oil, transformer oil, heat transfer oil and mixtures thereof. The above liquid working substance should be heat conducting liquid working substance with good insulation, to ensure the insulating performance of the working substance and avoid contact with the server components and then conducting electricity, resulting in electronic devices damage and system scrapping. The liquid working substance generally has a high thermal conductivity, and can directly contact with the heat-generating electronic devices in the spraying way, thereby realizing efficient heat dissipation of server

The server components 3 of the present invention comprise a processor, a hard disk, a memory, a system bus, etc. The heat generated by the server components3 is mainly derived from CPU, GPU, memory and other components. By adopting the cooling medium, which is insulated liquid heat conducting working substance, as non-polar material, to spray directly on the server components 3, the electronic, electrical equipment and circuit will not be affected and the hardware will not be damaged.

The above are only preferred embodiments of the present invention which is defined by the claims and are not intended to limit the scope thereof.

## Claims

1. A working substance contacted cooling system for computer and data center, wherein the system comprises:
a server cabinet (301); a heat-conducting liquid working substance with good insulation (101);
a liquid working substance box (1) arranged at a bottom of the server cabinet (301);
a liquid working substance cooling device configured to cool the heat-conducting liquid working substance with good insulation in the liquid working substance box (1);
a main conduit dispenser (4) vertically arranged, which is in communication with the liquid working substance box (1) through a main conduit (5); and
a liquid working substance pump (8) arranged in or outside the liquid working substance box (1) and the liquid working substance pump (8) is in communication with the main conduit dispenser (4);
and the system further comprises:
a plurality of partition plates (2) with holes or grooves, which are parallelly and horizontally arranged at different heights, and on which server components (3) are mounted; a plurality of liquid working substance spraying pipes (6), a plurality of spray orifices being uniformly arranged on each said liquid working substance spraying pipe (6), each said liquid working substance spraying pipe (6) being horizontally arranged above the server components (3) at the different heights respectively and being in communication with the main conduit dispenser (4); spraying directions of the spray orifices being corresponding to positions of the server components (3); a top of the liquid working substance box (1) is opened to allow heat-conducting liquid working substance with good insulation from the liquid working substance box (1) sprayed on the server components (3) to fall back into the liquid working substance box (1) and the working substance contacted cooling system is configured that no phase change occurs in the process of heat transferring when the heat-conducting liquid working substance with good insulation (101) directly contacts the server components (3) that need heat dissipation.

2. The working substance contacted cooling system for computer and data center according to claim 1, wherein a side wall of a lower part of the server cabinet (301) extends to form a side wall of the liquid working substance box (1), so that the side wall of the liquid working substance box (1) and the side wall of the lower part of the server cabinet (301) are formed in one piece; or, the liquid working substance box (1) comprises a first liquid working substance box and a second liquid working substance box, a top of the first liquid working substance box is opened, a side wall of a lower part of the server cabinet (301) extends to form a side wall of the first liquid working substance box, so that the side wall of the first liquid working substance box and the side wall of the lower part of the server cabinet (301) are formed in one piece, and the second liquid working substance box arranged outside the server cabinet (301) is in communication with the first liquid working substance box.

3. The working substance contacted cooling system for computer and data center according to claim 1, wherein the system further comprises a filter (9) installed at a front end of a liquid inlet of the liquid working substance pump (8).

4. The working substance contacted cooling system for computer and data center according to claim 1, wherein the liquid working substance cooling device comprises a water chiller; the water chiller comprising a refrigerant compressor (10), a refrigerant conveying tube (11), a refrigerant returning tube (12) and an evaporator (13); an outlet of the refrigerant compressor (10) being in communication with one end of the evaporator (13) through the refrigerant conveying tube (11), and an inlet of the refrigerant compressor (10) being in communication with the other end of the evaporator (13) through the refrigerant returning tube (12); the evaporator (13) being arranged in the liquid working substance box (1).

5. The working substance contacted cooling system for computer and data center according to claim 1, wherein the liquid working substance cooling device is a radiating fin (14) installed outside the liquid working substance box (1).

6. The working substance contacted cooling system for computer and data center according to claim 1, wherein the liquid working substance cooling device comprises a first heat exchange section (16) arranged outside the liquid working substance box (1) and a second heat exchange section (17) arranged in the liquid working substance box (1); a refrigerant outlet of the first heat exchange section (16) being in communication with a refrigerant inlet of the second heat exchange section (17), and a refrigerant outlet of the second heat exchange section (17) being in communication with a refrigerant inlet of the first heat exchange section (16).

7. The working substance contacted cooling system for computer and data center according to claim 5 or claim 6, wherein the system further comprises a blower (15) to cool the radiating fin (14) or the first heat exchange section (16).

8. The working substance contacted cooling system for computer and data center according to claim 1 or claim 2, wherein the heat-conducting liquid working substance with good insulation is selected from the group consisting of natural mineral oil, silicone oil, vegetable oil, transformer oil, heat transfer oil and mixtures thereof.

## Patentansprüche

1. Arbeitsmittelkontaktiertes Kühlsystem für Computer und Rechenzentren, wobei das System umfasst:
einen Serverschrank (301);
eine wärmeleitende Arbeitsflüssigkeit mit guter Isolierung (101);
einen Arbeitsflüssigkeitskasten (1), der an einem Boden des Serverschranks (301) angeordnet ist;
eine Arbeitsflüssigkeitskühlvorrichtung, die ausgelegt ist, die wärmeleitende Arbeitsflüssigkeit mit guter Isolierung im Arbeitsflüssigkeitskasten (1) zu kühlen;
einen vertikal angeordneten Hauptleitungsspender (4), der durch eine Hauptleitung (5) in Verbindung mit dem Arbeitsflüssigkeitskasten (1) steht; und
eine Arbeitsflüssigkeitspumpe (8), die innerhalb oder außerhalb des Arbeitsflüssigkeitskastens (1) angeordnet ist, und wobei die Arbeitsflüssigkeitspumpe (8) in Verbindung mit dem Hauptleitungsspender (4) steht;
und wobei das System ferner umfasst:
eine Vielzahl von Trennplatten (2) mit Löchern oder Nuten, die parallel und horizontal in unterschiedlichen Höhen angeordnet sind und auf denen Serverkomponenten (3) montiert sind; eine Vielzahl von Arbeitsflüssigkeitssprührohren (6), wobei eine Vielzahl von Sprühöffnungen gleichmäßig auf jedem Arbeitsflüssigkeitssprührohr (6) angeordnet ist, jedes Arbeitsflüssigkeitssprührohr (6) horizontal über den Serverkomponenten (3) an den jeweiligen unterschiedlichen Höhen angeordnet ist und in Verbindung mit dem Hauptleitungsspender (4) steht; wobei Sprührichtungen der Sprühöffnungen Positionen der Serverkomponenten (3) entsprechen; wobei eine Oberseite des Arbeitsflüssigkeitskastens (1) geöffnet ist, um der auf die Serverkomponenten (3) gesprühten wärmeleitenden Arbeitsflüssigkeit mit guter Isolierung vom Arbeitsflüssigkeitskasten (1) zu ermöglichen, zurück in den Arbeitsflüssigkeitskasten (1) zu fallen, und wobei das arbeitsmittelkontaktierte Kühlsystem so ausgelegt ist, dass kein Phasenübergang bei einem Wärmeübertragungsprozess stattfindet, wenn die wärmeleitende Arbeitsflüssigkeit mit guter Isolierung (101) direkt die Serverkomponenten (3) berührt, die eine Wärmeableitung benötigen.

2. Arbeitsmittelkontaktiertes Kühlsystem für Computer und Rechenzentren nach Anspruch 1, wobei eine Seitenwand eines unteren Teils des Serverschranks (301) so verläuft, dass sie eine Seitenwand des Arbeitsflüssigkeitskastens (1) bildet, sodass die Seitenwand des Arbeitsflüssigkeitskastens (1) und die Seitenwand des unteren Teils des Serverschranks (301) in einem Stück gebildet sind; oder der Arbeitsflüssigkeitskasten (1) einen ersten Arbeitsflüssigkeitskasten und einen zweiten Arbeitsflüssigkeitskasten umfasst, wobei eine Oberseite des ersten Arbeitsflüssigkeitskastens geöffnet ist, wobei eine Seitenwand eines unteren Teils des Serverschranks (301) so verläuft, dass sie eine Seitenwand des ersten Arbeitsflüssigkeitskastens bildet, sodass die Seitenwand des ersten Arbeitsflüssigkeitskastens und die Seitenwand des unteren Teils des Serverschranks (301) in einem Stück gebildet sind und der zweite Arbeitsflüssigkeitskasten, der außerhalb des Serverschranks (301) angeordnet ist, in Verbindung mit dem ersten Arbeitsflüssigkeitskasten steht.

3. Arbeitsmittelkontaktiertes Kühlsystem für Computer und Rechenzentren nach Anspruch 1, wobei das System ferner einen Filter (9) umfasst, der an einem vorderen Ende eines Flüssigkeitseinlasses der Arbeitsflüssigkeitspumpe (8) installiert ist.

4. Arbeitsmittelkontaktiertes Kühlsystem für Computer und Rechenzentren nach Anspruch 1, wobei die Arbeitsflüssigkeitskühlvorrichtung einen Wasserkühler umfasst; wobei der Wasserkühler einen Kühlmittelkompressor (10), ein Kühlmittelförderrohr (11), ein Kühlmittelrückführrohr (12) und einen Verdampfer (13) umfasst; wobei ein Auslass des Kühlmittelkompressors (10) durch das Kühlmittelförderrohr (11) in Verbindung mit einem Ende des Verdampfers (13) steht und ein Einlass des Kühlmittelkompressors (10) durch das Kühlmittelrückführrohr (12) mit dem anderen Ende des Verdampfers (13) steht; wobei der Verdampfer (13) im Arbeitsflüssigkeitskasten (1) angeordnet ist.

5. Arbeitsmittelkontaktiertes Kühlsystem für Computer und Rechenzentren nach Anspruch 1, wobei die Arbeitsflüssigkeitskühlvorrichtung eine Abstrahlrippe (14) ist, die außerhalb des Arbeitsflüssigkeitskastens (1) installiert ist.

6. Arbeitsmittelkontaktiertes Kühlsystem für Computer und Rechenzentren nach Anspruch 1, wobei die Arbeitsflüssigkeitskühlvorrichtung einen ersten Wärmetauscherabschnitt (16), der außerhalb des Arbeitsflüssigkeitskastens (1) angeordnet ist, und einen zweiten Wärmetauscherabschnitt (17) umfasst, der im Arbeitsflüssigkeitskasten (1) angeordnet ist; wobei ein Kühlmittelauslass des ersten Wärmetauscherabschnitts (16) in Verbindung mit einem Kühlmitteleinlass des zweiten Wärmetauscherabschnitts (17) steht und ein Kühlmittelauslass des zweiten Wärmetauscherabschnitts (17) in Verbindung mit einem Kühlmitteleinlass des ersten Wärmetauscherabschnitts (16) steht.

7. Arbeitsmittelkontaktiertes Kühlsystem für Computer und Rechenzentren nach Anspruch 5 oder Anspruch 6, wobei das System ferner ein Gebläse (15) umfasst, um die Abstrahlrippe (14) oder den ersten Wärmetauscherabschnitt (16) zu kühlen.

8. Arbeitsmittelkontaktiertes Kühlsystem für Computer und Rechenzentren nach Anspruch 1 oder Anspruch 2, wobei die wärmeleitende Arbeitsflüssigkeit mit guter Isolierung aus der Gruppe ausgewählt ist, die aus natürlichem Mineralöl, Silikonöl, Pflanzenöl, Transformatoröl, Thermoöl und Mischungen davon besteht.

## Revendications

1. Système de refroidissement à contact avec une substance active pour ordinateur et centre de données, dans lequel le système comprend :
une armoire à serveurs (301) ;
une substance active liquide thermoconductrice avec une bonne isolation (101) ;
une boîte pour substance active liquide (1) agencée au niveau d'un fond de l'armoire à serveurs (301) ;
un dispositif de refroidissement à substance active liquide configuré pour refroidir la substance active liquide thermoconductrice avec une bonne isolation dans la boîte pour substance active liquide (1) ;
un distributeur de conduite principale (4) agencé verticalement, qui est en communication avec la boîte pour substance active liquide (1) à travers une conduite principale (5) ; et
une pompe à substance active liquide (8) agencée dans ou en dehors de la boîte pour substance active liquide (1) et la pompe à substance active liquide (8) est en communication avec le distributeur de conduite principale (4) ;
et le système comprend en outre :
une pluralité de plaques de séparation (2) avec des trous ou rainures, qui sont agencées parallèlement et horizontalement à différentes hauteurs, et sur lesquelles des composants de serveur (3) sont montés ; une pluralité de tuyaux de pulvérisation de substance active liquide (6), une pluralité d'orifices de pulvérisation étant agencés uniformément sur chaque dit tuyau de pulvérisation de substance active liquide (6), chaque dit tuyau de pulvérisation de substance active liquide (6) étant agencé horizontalement au-dessus des composants de serveur (3) aux différentes hauteurs respectivement et étant en communication avec le distributeur de conduite principale (4) ; des directions de pulvérisation des orifices de pulvérisation étant correspondantes à des positions des composants de serveur (3) ; une partie supérieure de la boîte pour substance active liquide (1) est ouverte pour permettre à de la substance active liquide thermoconductrice avec une bonne isolation provenant de la boîte pour substance active liquide (1) pulvérisée sur les composants de serveur (3) de retomber dans la boîte pour substance active liquide (1), et le système de refroidissement à contact avec une substance active est configuré pour qu'aucun changement de phase ne se produise dans le processus de transfert thermique lorsque la substance active liquide thermoconductrice avec une bonne isolation (101) vient directement en contact avec les composants de serveur (3) qui ont besoin de dissipation thermique.

2. Système de refroidissement à contact avec une substance active pour ordinateur et centre de données selon la revendication 1, dans lequel une paroi latérale d'une partie inférieure de l'armoire à serveurs (301) s'étend pour former une paroi latérale de la boîte pour substance active liquide (1) de sorte que la paroi latérale de la boîte pour substance active liquide (1) et la paroi latérale de la partie inférieure de l'armoire à serveurs (301) sont formées en une pièce ; ou la boîte pour substance active liquide (1) comprend une première boîte pour substance active liquide et une seconde boîte pour substance active liquide, une partie supérieure de la première boîte pour substance active liquide est ouverte, une paroi latérale d'une partie inférieure de l'armoire à serveurs (301) s'étend pour former une paroi latérale de la première boîte pour substance active liquide de sorte que la paroi latérale de la première boîte pour substance active liquide et la paroi latérale de la partie inférieure de l'armoire à serveurs (301) sont formées en une pièce, et la seconde boîte pour substance active liquide agencée en dehors de l'armoire à serveurs (301) est en communication avec la première boîte pour substance active liquide.

3. Système de refroidissement à contact avec une substance active pour ordinateur et centre de données selon la revendication 1, dans lequel le système comprend en outre un filtre (9) installé à une extrémité avant d'une entrée de liquide de la pompe à substance active liquide (8).

4. Système de refroidissement à contact avec une substance active pour ordinateur et centre de données selon la revendication 1, dans lequel le dispositif de refroidissement à substance active liquide comprend un refroidisseur d'eau ; le refroidisseur d'eau comprenant un compresseur de réfrigérant (10), un tube de transport de réfrigérant (11), un tube de renvoi de réfrigérant (12) et un évaporateur (13) ; une sortie du compresseur de réfrigérant (10) étant en communication avec une extrémité de l'évaporateur (13) à travers le tube de transport de réfrigérant (11), et une entrée du compresseur de réfrigérant (10) étant en communication avec l'autre extrémité de l'évaporateur (13) à travers le tube de renvoi de réfrigérant (12) ; l'évaporateur (13) étant agencé dans la boîte pour substance active liquide (1).

5. Système de refroidissement à contact avec une substance active pour ordinateur et centre de données selon la revendication 1, dans lequel le dispositif de refroidissement à substance active liquide est une ailette de radiateur (14) installée en dehors de la boîte pour substance active liquide (1).

6. Système de refroidissement à contact avec une substance active pour ordinateur et centre de données selon la revendication 1, dans lequel le dispositif de refroidissement à substance active liquide comprend une première section d'échange de chaleur (16) agencée en dehors de la boîte pour substance active liquide (1) et une seconde section d'échange de chaleur (17) agencée dans la boîte pour substance active liquide (1) ; une sortie de réfrigérant de la première section d'échange de chaleur (16) étant en communication avec une entrée de réfrigérant de la seconde section d'échange de chaleur (17), et une sortie de réfrigérant de la seconde section d'échange de chaleur (17) étant en communication avec une entrée de réfrigérant de la première section d'échange de chaleur (16).

7. Système de refroidissement à contact avec une substance active pour ordinateur et centre de données selon la revendication 5 ou la revendication 6, dans lequel le système comprend en outre un ventilateur (15) pour refroidir l'ailette de radiateur (14) ou la première section d'échange de chaleur (16).

8. Système de refroidissement à contact avec une substance active pour ordinateur et centre de données selon la revendication 1 ou la revendication 2, dans lequel la substance active liquide thermoconductrice avec une bonne isolation est sélectionnée parmi le groupe constitué d'huile minérale naturelle, d'huile de silicone, d'huile végétale, d'huile de transformation, d'huile de transfert thermique et de mélanges de celles-ci.
